# EUROPÄISCHE PATENTSCHRIFT

(11) **EP 0 565 781 B1**
(45) Veröffentlichungstag und Bekanntmachung des Hinweises auf die Patenterteilung: **29.11.1995**
(21) Anmeldenummer: 92201041.8
(22) Anmeldetag: 13.04.1992
(51) Int. Cl.: H05K 13/04, H01L 21/00

(54) **Ausstossvorrichtung zum Abtrennen eines Chips von einem adhäsiven Träger**
Ejecting device for separating a chip from an adhesive tape
Dispositif d'expulsion pour séparer une puce d'une bande adhésive

(43) Veröffentlichungstag der Anmeldung: 20.10.1993
(73) Patentinhaber: Miroslav, Tresky, Dr.Ing., CH-8800 Thalwil (CH)
(72) Erfinder: Miroslav, Tresky, Dr.Ing., CH-8800 Thalwil (CH)
(74) Vertreter: Spicak-Malcova, Hana

(56) Entgegenhaltungen:
- US-A- 4 472 218
- US-A- 4 850 780

## Beschreibung

Die Erfindung betrifft einen Diebonder mit einer Ausstosvorrichtung zum Abtrennen eines Chips (Dies ) von einem Adhäsivträger, die eine in einer Ausstosserbüchse koaxial angeordnete Austossernadel und eine mit dem Adhäsivträger wirkverbundene Ansaugeinrichtung aufweist, und mit einem den Chip aufnehmenden Werkzeug, siehe beispielsweise US-A-4 472 218.

Bei allen bisher bekannten Diebondern ist die Austossnadel jeweils einem in einer ortsfesten Ansstosserbüchse angeordneten antreibbaren Teil zugeordnet.
Die Ausstossnadel wird mit dem Teil nach oben beschleunigt, dringt den Adhäsivträger (beispielweise eine Selbstklebende Folie) hindurch und wirkt auf den Chip und über diesen auch auf das Vakuumwerkzeug ein, das den Chip aufpickt. Die dabei entstehenden dynamischen Kräfte belasten den sehr dünnen und brüchigen Chip erheblich. Mit Beweglichkeit der Ausstossnadel ist unvermeidlich eine grössere Ungenauigkeit der axialen Uebereinstimmung zwischen der Ausstossnadel und dem Vakuumwerkzeug vorhanden. Dies kann bei einer ungünstigen Toleranzkombination sogar zur Kollision zwischen der Ausstossnadel und dem Vakuumwerkzeug führen.
Der eventuelle Chipbruch hat ausserdem eine Verunreinigung der vorhandenen Vakuumkanäle zur Folge.

Die Erfindung, wie sie in den Ansprüchen gekennzeichnet ist, löst die Aufgabe, einen Diebonder zu schaffen, bei dem in einfacher Weise die Chipbruchgefahr und die Beschädigung der Ausstossnadel und des Vakuumwerkzeuges beim Aufpicken des Chips vermieden wird.

Die besonderen Vorteile des erfindungsgemässen Diebonders sind in grösserer Funktionzuverlässigkeit und Produktionsleistung zu erblicken.

Zwei Ausführungsbeispiele des Erfindungsgegenstandes sind in der Zeichnung dargestellt und im folgenden näher beschrieben.

Es zeigen:
- Fig. 1: eine schematische Darstellung eines Diebonders im Schnitt nach dem ersten Beispiel.
- Fig. 2: einen Teilschnitt durch eine Anstossvorrichtung nach dem zweiten Beispiel.
- Fig. 3: eine Draufsicht auf eine in Fig.2 dargestellte Austosserbüchse.

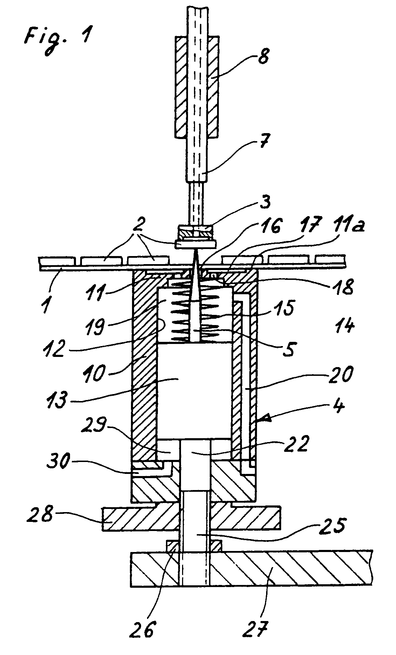

Gemäss Fig.1 ist ein Adhäsivträger 1, beispielsweise eine selbstklebende Folie, mit einer Anzahl Chips 2 versehen. Der Adhäsivträger 1 ist in nicht näher dargestellten Weise einer XY-Positionierungseinrichtung zugeordnet, über welche die einzelnen Chips 2 in horizontaler Ebene gegenüber einem Vakuumwerkzeug 3 und einer gegenüberliegenden Ausstossvorrichtung 4 plaziert werden.

Das Vakuumwerkzeug 3 ist mit seiner Werkzeugachse 7 einer Vertikalführung 8 zugeordnet und über diese vertikal verstellbar.

Die Ausstossvorrichtung 4 weist eine hülsenförmige Ausstosserbüchse 10 auf, die einen dem Adhäsivträger 1 zugewandten Frontteil 11 sowie eine Bohrung 12 aufweist. In der Bohrung 12 ist ein Kolben 13 angeordnet, der auf seiner oberen Stirnfläche 14 mit einer Ausstossnadel 5 versehen ist. Zwischen dem Kolben 13 bzw. seiner Stirnfläche 14 und der Ausstosserbüchse 10 bzw. ihrem Frontteil 11 ist eine Feder 15 abgestützt. Der Frontteil 11 weist ferner eine Zentralöffnung 16 auf, in welche in der in Fig.1 dargestellten Stellung die Ausstossnadel 5 hineinragt. Zudem ist der Frontteil 11 auf seiner Stirnseite 11a mit einer Anzahl Rillen 17 versehen, die über Bohrungen 18 mit dem oberhalb des Kolbens 13 vorhandenen Raum 19 verbunden sind. Dieser Raum 19 ist über einen schematisch dargestellten Kanal 20 mit einer nicht näher dargestellten Vakuumquelle verbunden. Die Rillen 17 und die Bohrungen 18 bilden eine Ansaugeinrichtung für den Adhäsivträger 1.

Im unteren Bereich ist der Kolben 13 mit einem Bolzen 22 ausgestattet, der aus der Ausstosserbüchse 10 sowie einem die Ausstosserbüchse zuschliessenden Boden 23 hinausragt und über einen schraubenförmigen Teil 25 und eine Mutter 26 an einem Diebonderrahmen 27 befestigt ist.
Auf dem Schraubenförmigen Teil 25 ist ferner eine Stellmutter 28 aufgeschraubt, über welche die Ausstosserbüchse 10 relativ zum Diebonderrahmen 27 und somit auch zum Kolben 13 höhenverstellbar ist. Eine unterhalb des Kolbens 13 in der Ausstosserbüchse 10 gebildeter Raum 29, dessen Grösse von der Einstellung der Stellmutter 28 abhängig ist, ist über einen Kanal 30 mit einer nicht näher dargestellten Druckluftquelle verbunden.

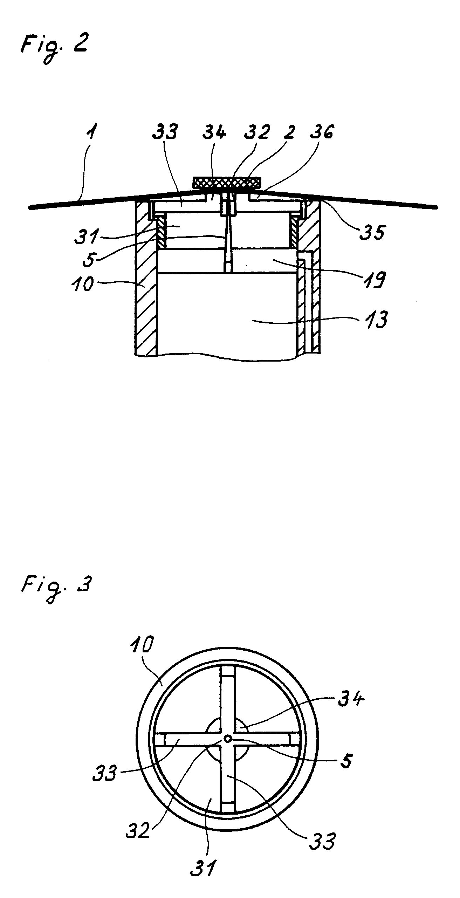

Gemäss Fig.2 und 3 ist die Ausstosserbüchse 10 mit einem Fronteinsatz 31 versehen, der eine zentrale Erhöhung 34 aufweist. Die Zentralerhöhung 34 ragt aus der Ausstosserbüchse 10 über den Büchsenrand 35 nach oben hinaus.
Im Fronteinsatz 31 sind mehrere, gegebenenfalls vier radiale Einschnitte 33 angefertigt, die eine Zentralöffnung 32 für die Ausstossnadel 5 bilden. Der den Chip 2 tragende Adhäsivträger 1 ist an der Erhöhung 34 und aus dem etwas zurückversetzten Büchsenrand 35 abgestützt, so dass zwischen dem Adhäsivträger 1 und dem Fronteinsatz 31 ein zusätzlicher Vakuumfüllbarer Raum 36 entsteht. Die Ansaugeeinrichtung ist bei dieser Ausführungform durch die Einschnitte 33 und dem zusätzlichen Raum 33 gebildet.

Die Wirkungsweise des beschriebenen Diebonders ist wie folgt.

In der Ausgangslage der Ausstosservorrichtung 4 befindet sich die Ausstosserbüchse 10 in der obersten Stellung, in welcher sich die Ausstossnadel 5 unterhalb des Adhäsivträger 1 befindet. Nachdem der zu bearbeitende Chip 2 mit Hilfe der XY-Positionierungseinrichtung in die mit dem Vakuumwerkzeug 3 koaxiale Stellung gebracht wurde, wird über den Kanal 20, im Raume 19 Vakuum hergestellt. Bei der Ausführungsform nach Fig. 2 und 3 entsteht das Vakuum auch im zusätzlichen Raum 36. Der Adhäsivträger 1 wird an den Frontteil 11 bzw. an den Fronteinsatz 31 und den Büchsenrand 35 angesaugt. Bei der zweiten Ausführungsform wird schon bei diesem Vorgang der Chip vom Adhäsivträger 1 über die Erhöhung 34 teilweise abgetrennt.

Durch eine anschliessende Druckluftzufuhr in den Raum 29 unterhalb des Kolbens 13 wird die Ausstosserbüchse 10 relativ gegenüber dem ortsfesten Kolben 12 und somit auch gegenüber der Ausstossnadel 5 entgegen der Kraft der Feder 15 nach unten bewegt. Auch der angesaugte Adhäsivträger 1 wird mitbewegt. Die Ausstossnadel 5 sticht dabei den Adhäsivträger ( z.B. eine Kunststoffolie) hindurch und hebt den Chip 2 entsprechend der Fig. 1 an.
Dieser wird vom Vakuumwerkzeug 3 erfasst und in nicht dargestellter Weise einem Bestückungsobjekt zugeführt.

Dadurch, dass nicht die Ausstossnadel 5 sondern die Ausstosserbüchse 10 über Druckluft beschleunigt wird (ausser Druckluftbeschleunigung könnte durchaus auch eine mechanische oder elektromagnetische Betätigung stattfinden), werden keine dynamischen Kräfte von der Ausstossnadel 5 auf den Chip 2 übertragen, so dass die Chipbruchgefahr und somit auch die Beschädigungsgefahr für die Ausstossnadel 5 und das Vakuumwerkzeug 3 vermieden wird.
Die ortsfeste Ausstossnadel 5 kann zudem exakt koaxial zum Vakuumwerkzeug 3 am Diebonderrahmen 27 befestigt werden, wodurch ein exakteres Anheben des Chips 2 beim Aufpicken auf das Vakuumwerkzeug 3 ohne evt. Kippen des Chips 2 - stattfinden kann.

Ueber die Stellmutter 28 kann die Hubgrösse der beweglichen Teile der Ausstossvorrichtung 4 je nach Gebrauch eingestellt werden.

## Patentansprüche

1. Diebonder mit einer Ausstossvorrichtung zum Abtrennen eines Chips von einem Adhäsivträger, die eine in einer Ausstosserbüchse koaxial angeordnete Ausstossernadel und eine mit dem Adhäsivträger wirkverbundene Ansaugeinrichtung aufweist, und mit einem den Chip aufnehmenden Werkzeug, dadurch gekennzeichnet, dass die Ausstossnadel (5) ortsfest angeordnet ist und dass die den Adhäsivträger ansaugende Ausstosserbüchse (10) relativ gegenüber der Ausstossernadel (5) verstellbar ist.

2. Diebonder nach Anspruch 1, dadurch gekennzeichnet, dass die Ausstosserbüchse (10) einen dem Adhäsivträger (1) zugewandten Frontteil (11) aufweist, der auf seiner Stirnseite (11a) mit mindestens einer Rille (17) versehen ist, die über Bohrungen (18) mit einem vakuumfüllbaren Raum (19) in der Ausstosserbüchse (10) verbunden sind, und der mit einer Zentralöffnung (16) für die Ausstossnadel (5) versehen ist.

3. Diebonder nach Anspruch 1, dadurch gekennzeichnet, dass in der Ausstosserbüchse (10) auf der dem Adhäsivträger (1) zugewandten Seite ein Fronteinsatz (31) eingesetzt ist, der mit mehreren radialen, in einen vakuumfüllbaren Raum (19) mündenden Einschnitten (33) versehen ist.

4. Diebonder nach Anspruch 3, dadurch gekennzeichnet, dass der Fronteinsatz (31) eine zentrale Erhöhung (34) aufweist.

5. Diebonder nach Anspruch 3, dadurch gekennzeichnet, dass die Einschnitte (33) eine Zentralöffnung (32) für die Ausstossnadel(5) bilden.

## Claims

1. A die bonder comprising an ejecting device for separating a chip from an adhesive support, the said ejecting device having an ejector needle arranged coaxially in an ejector sleeve and a suction device operatively engaging the adhesive support, and comprising a chip-receiving tool, characterised in that the ejector needle (5) is arranged in a fixed manner and in that the ejector sleeve (10) sucking the adhesive support is displaceable relative to the ejector needle (5).

2. A die bonder according to claim 1, characterised in that the ejector sleeve (10) has a front part (11) facing the adhesive support (1), the front end (11a) of the said front part (11) being provided with at least one groove (17) communicating with a vacuum-fillable space (19) in the ejector sleeve (10) via bores (18), and the said front part (11) being provided with a central opening (16) for the ejector needle (5).

3. A die bonder according to claim 1, characterised in that a front insert (31) is inserted into the ejector sleeve (10) on the side facing the adhesive support (1), the said front insert (31) being provided with a plurality of radial recesses (33) opening into a vacuum-fillable space (19).

4. A die bonder according to claim 3, characterised in that the front insert (31) has a central elevation (34).

5. A die bonder according to claim 3, characterised in that the recesses (33) form a central opening (32) for the ejector needle (5).

## Revendications

1. Soudeuse de puces électronique comportant un dispositif d'éjection pour séparer une puce d'un support adhésif qui présente une aiguille d'éjecteur disposée coaxialement à l'intérieur d'une douille d'éjection et un dispositif d'aspiration en liaison active avec le support adhésif, et comportant en outre un outil pour saisir la puce, caractérisée par le fait que l'aiguille d'éjection (5) est fixe en position et que la douille d'éjecteur (10) aspirant le support adhésif est mobile par rapport à l'aiguille d'éjecteur (5).

2. Soudeuse selon la revendication 1, caractérisée par le fait que la douille d'éjecteur (10) présente une partie frontale (11) tournée vers le support adhésif (1), pourvue, sur sa face frontale (11a), d'au moins d'une gorge (17) reliée à une chambre (19) dans la douille d'éjecteur (10) et dans laquelle on peut faire le vide, par des perçages (18), et qui est également pourvue d'une ouverture centrale (16) pour l'aiguille d'éjection (5).

3. Soudeuse selon la revendication 1, caractérisée par le fait qu'une garniture frontale (31) est disposée dans la douille d'éjecteur (10) sur la face tournée vers le support adhésif (1) et est pourvue de plusieurs entailles (33) radiales débouchant dans une chambre à vide (19).

4. Soudeuse selon la revendication 3, caractérisée par le fait que la garniture frontale (31) présente un relief central (34).

5. Soudeuse selon la revendication 3, caractérisée par le fait que les entailles (33) forment une ouverture centrale (32) pour l'aiguille d'éjection (5).
